(19) Europäisches Patentamt / European Patent Office / Office européen des brevets

(11) **EP 3 181 940 B2**

(12) **NOUVEAU FASCICULE DE BREVET EUROPEEN**
Après la procédure d'opposition

(45) Date de publication et mention de la décision concernant l'opposition:
**05.07.2023 Bulletin 2023/27**

(45) Mention de la délivrance du brevet:
**06.02.2019 Bulletin 2019/06**

(21) Numéro de dépôt: **15201341.3**

(22) Date de dépôt: **18.12.2015**

(51) Classification Internationale des Brevets (IPC):
**F16F 1/10** (2006.01)    **G04D 7/10** (2006.01)
**G04B 17/06** (2006.01)    **G04D 7/08** (2006.01)

(52) Classification Coopérative des Brevets (CPC):
**G04B 17/066; B81C 1/00; F16F 1/10; G04B 17/22; G04D 7/10**

(54) **PROCEDE DE FABRICATION D'UN SPIRAL D'UNE RAIDEUR PREDETERMINEE PAR RETRAIT LOCALISE DE MATIERE**

HERSTELLUNGSVERFAHREN EINER SPIRALFEDER MIT EINER VORBESTIMMTEN STEIFIGKEIT DURCH LOKALISIERTE WEGNAHME VON MATERIAL

METHOD FOR MANUFACTURING A HAIRSPRING WITH A PREDETERMINED STIFFNESS BY LOCALISED REMOVAL OF MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**21.06.2017 Bulletin 2017/25**

(73) Titulaire: **CSEM Centre Suisse d'Electronique et de Microtechnique SA - Recherche et Développement**
**2002 Neuchâtel (CH)**

(72) Inventeurs:
• **KOHLER, Frédéric**
**1754 Avry-sur-Matran (CH)**
• **BUCAILLE, Jean-Luc**
**74160 Présilly (FR)**
• **HUNZIKER, Olivier**
**1800 Vevey (CH)**

(74) Mandataire: **Hoffmann Eitle et al Patent- und Rechtsanwälte PartmbB**
**Arabellastraße 30**
**81925 München (DE)**

(56) Documents cités:
EP-A1- 1 213 628    EP-A1- 2 423 764
EP-A1- 2 455 825    WO-A1-2012/007460
WO-A1-2015/113973    CH-A2- 709 516

EP 3 181 940 B2

**Description**

Domaine de l'invention

L'invention se rapporte à un procédé de fabrication d'un spiral d'une raideur prédéterminée et, plus précisément, un tel spiral utilisé comme spiral compensateur coopérant avec un balancier d'inertie prédéterminée pour former un résonateur comportant une fréquence prédéterminée.

Arrière-plan de l'invention

Il est expliqué dans le document EP 1 422 436 comment former un spiral compensateur comportant une âme en silicium revêtue de dioxyde de silicium et coopérant avec un balancier d'inertie prédéterminée pour compenser thermiquement l'ensemble dudit résonateur.

Fabriquer un tel spiral compensateur apporte de nombreux avantages mais possède également des inconvénients. En effet, l'étape de gravage de plusieurs spiraux dans une plaquette de silicium offre une dispersion géométrique non négligeable entre les spiraux d'une même plaquette et une dispersion plus grande entre des spiraux de deux plaquettes gravées à des moments différents. Incidemment, la raideur de chaque spiral gravé avec le même motif de gravage est variable en créant des dispersions de fabrication non négligeables. EP1213628 montre un procédé de réglage de la fréquence d'oscillation d'un ensemble régulateur destiné à ou équipant une pièce d'horlogerie mécanique dans lequel on effectue un usinage du spiral au moyen d'un faisceau laser de manière à diminuer son couple élastique jusqu'à ce que ladite fréquence d'oscillation soit sensiblement égale à ladite fréquence de référence.

Résumé de l'invention

Le but de la présente invention est de pallier tout ou partie des inconvénients cités précédemment en proposant un procédé de fabrication d'un spiral dont les dimensions sont suffisamment précises pour ne pas nécessiter de retouche.

A cet effet, l'invention se rapporte à un procédé de fabrication d'un spiral d'une raideur prédéterminée selon revendication 1.

On comprend donc que le procédé permet de garantir une très haute précision dimensionnelle du spiral et, incidemment, de garantir une raideur plus précise dudit spiral. Chaque paramètre de fabrication, pouvant induire des variations géométriques lors de l'étape a), peut ainsi être totalement rectifié pour chaque spiral fabriqué ou rectifié en moyenne pour l'ensemble des spiraux formés sur une même plaquette permettant de diminuer drastiquement le taux de rebut. De plus, le caractère non homogène du retrait de matériau effectué à l'étape d) peut conférer des avantages supplémentaires au spiral, en termes notamment de simplicité de fabrication.

Conformément à d'autres variantes avantageuses de l'invention :

- lors de l'étape a), les dimensions du spiral formé lors de l'étape a) sont entre 1% et 20% supérieures à celles nécessaires pour obtenir ledit spiral à ladite raideur prédéterminée ;
- l'étape a) est réalisée à l'aide d'un gravage ionique réactif profond ou d'un gravage chimique ;
- lors de l'étape a), plusieurs spiraux sont formés dans une même plaquette selon des dimensions supérieures aux dimensions nécessaires pour obtenir plusieurs spiraux d'une raideur prédéterminée ou plusieurs spiraux de plusieurs raideurs prédéterminées ;
- le spiral formé lors de l'étape a) est à base de silicium, de verre, de céramique, de métal ou d'alliage métallique ;
- l'étape b) comporte les phases b1) : mesurer la fréquence d'un ensemble comportant le spiral formé lors de l'étape a) couplé avec un balancier doté d'une inertie prédéterminée et b2) : déduire de la fréquence mesurée, la raideur du spiral formé lors de l'étape a) ;
- selon une première variante, l'étape d) comporte la phase d1) : usiner au moyen d'un laser le spiral formé lors de l'étape a) afin d'obtenir le spiral aux dimensions nécessaires à ladite raideur prédéterminée ;
- selon une deuxième variante, l'étape d) comporte les phases d1) : oxyder le spiral formé lors de l'étape a) afin de transformer ladite épaisseur de matériau à base de silicium à retirer en dioxyde de silicium et ainsi former un spiral oxydé, et d2) : retirer l'oxyde du spiral oxydé permettant d'obtenir le spiral aux dimensions nécessaires à ladite raideur prédéterminée ;
- selon une troisième variante, l'étape d) comporte la phase d3) : graver chimiquement le spiral formé lors de l'étape a) afin d'obtenir le spiral aux dimensions nécessaires à ladite raideur prédéterminée ;
- après l'étape d), le procédé effectue au moins une nouvelle fois les étapes b), c) et d) pour affiner la qualité dimensionnelle ;
- après l'étape d), le procédé comporte, en outre, l'étape e) : former, sur au moins une partie dudit spiral d'une raideur prédéterminée, une portion permettant de corriger la raideur du spiral et de former un spiral moins sensible aux variations thermiques ;
- selon une première variante, l'étape e) comporte la phase e1) : déposer une couche sur une partie de la surface externe dudit spiral d'une raideur prédéterminée ;
- selon une deuxième variante, l'étape e) comporte la phase e2) : modifier la structure selon une profondeur prédéterminée d'une partie de la surface externe dudit spiral d'une raideur prédéterminée ;
- selon une troisième variante, l'étape e) comporte la phase e3) : modifier la composition selon une profondeur prédéterminée d'une partie de la surface externe dudit spiral d'une raideur prédéterminée ;

- lors de l'étape d), ladite épaisseur de matériau est retirée de telle manière que ledit spiral d'une raideur prédéterminée produise un écart de marche dû au défaut de concentricité de son développement qui soit égal ou qui diffère au maximum de ±5 secondes/jour, de l'écart de marche correspondant produit par le spiral formé lors de l'étape a), lesdits écarts de marche étant mesurés chacun à une amplitude d'oscillation de 150° par rapport à une amplitude d'oscillation de 330° ;

- lors de l'étape d), ladite épaisseur de matériau est retirée dans des premières zones discrètes du spiral formé lors de l'étape a) et n'est pas retirée dans des deuxièmes zones discrètes qui alternent avec les premières zones discrètes le long du spiral ;

- les premières zones discrètes ont sensiblement la même étendue angulaire ;

- les premières zones discrètes sont réparties sensiblement régulièrement tout le long dudit spiral formé lors de l'étape a) :

  - les deuxièmes zones discrètes ont sensiblement la même étendue angulaire ;

  - les deuxièmes zones discrètes ont sensiblement la même étendue angulaire que les premières zones discrètes ;

  - les premières zones discrètes ont chacune une étendue angulaire inférieure à environ 140° ou comprise entre environ 240° et environ 360°;

  - lors de l'étape d), ladite épaisseur de matériau est retirée selon l'épaisseur, selon la hauteur ou selon l'épaisseur et la hauteur du spiral formé lors de l'étape a).

Description sommaire des dessins

D'autres particularités et avantages ressortiront clairement de la description qui en est faite ci-après, à titre indicatif et nullement limitatif, en référence aux dessins annexés, dans lesquels :

- la figure 1 est une vue en perspective d'un résonateur assemblé selon l'invention ;
- la figure 2 est un exemple de géométrie de spiral selon l'invention ;
- les figures 3 à 5 sont des sections de spiral à différentes étapes du procédé selon l'invention ;
- la figure 6 est une représentation en perspective d'une étape du procédé selon l'invention ;
- la figure 7 est un diagramme du procédé selon l'invention ;
- les figures 8 et 9 montrent deux spiraux selon l'invention présentant des répartitions non homogènes de matière différentes ;

- la figure 10 montre des sections de deux zones discrètes de l'un ou l'autre des spiraux illustrés aux figures 8 et 9 ;

- la figure 11 montre cinq courbes d'isochronisme obtenues respectivement avec cinq spiraux différents ;

- la figure 12 montre à une échelle agrandie quatre des cinq courbes d'isochronisme précitées ;

- la figure 13 est un diagramme d'écart de marche relatif d'un balancier-spiral en fonction d'un paramètre de répartition non homogène de matière sur le spiral.

Description détaillée des modes de réalisation préférés

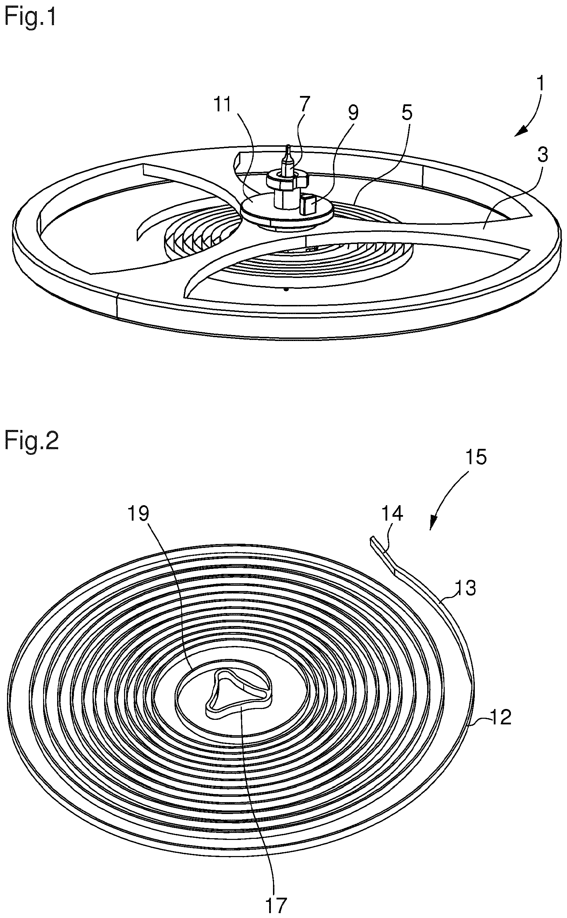

Comme illustré à la figure 1, l'invention se rapporte à un résonateur 1 du type balancier 3 - spiral 5. Le balancier 3 et le spiral 5 sont préférentiellement montés sur le même axe 7. Dans un tel résonateur 1, le moment d'inertie $I$ du balancier 3 répond à la formule :

$$I = mr^2 \qquad (1)$$

dans laquelle $m$ représente sa masse et $r$ son rayon de giration qui dépend également de la température par l'intermédiaire du coefficient de dilatation $\alpha_b$ du balancier.

De plus, la raideur $C$ d'un spiral 5 à section constante répond à la formule :

$$C = \frac{Ehe^3}{12L} \qquad (2)$$

dans laquelle $E$ est le module d'Young du matériau utilisé, $h$ sa hauteur, $e$ son épaisseur et $L$ sa longueur développée.

De plus, la raideur $C$ d'un spiral 5 à section variable répond à la formule :

$$C = \frac{E}{12} \frac{1}{\int_0^L \frac{1}{h(l)e^3(l)} dl} \qquad (3)$$

dans laquelle $E$ est le module d'Young du matériau utilisé, $h$ sa hauteur, $e$ son épaisseur, $L$ sa longueur développée et $l$ l'abscisse curviligne le long de la spire.

De plus, la raideur $C$ d'un spiral 5 à épaisseur variable mais à hauteur constante répond à la formule :

$$C = \frac{Eh}{12} \frac{1}{\int_0^L \frac{1}{e^3(l)} dl} \qquad (4)$$

dans laquelle *E* est le module d'Young du matériau utilisé, *h* sa hauteur, *e* son épaisseur, *L* sa longueur développée et *l* l'abscisse curviligne le long de la spire.

Enfin, la fréquence *f* du résonateur 1 balancier-spiral répond à la formule :

$$f = \frac{1}{2\pi}\sqrt{\frac{C}{I}} \qquad (5)$$

Selon l'invention, il est souhaité que la variation de la fréquence en fonction de la température d'un résonateur soit sensiblement nulle. La variation de la fréquence *f* en fonction de la température *T* dans le cas d'un résonateur balancier-spiral suit sensiblement la formule suivante :

$$\frac{\Delta f}{f} = \frac{1}{2}\left\{\frac{\partial E}{\partial T}\frac{1}{E} + 3\cdot\alpha_s - 2\cdot\alpha_b\right\}\cdot\Delta T \qquad (6)$$

où :

- $\dfrac{\Delta f}{f}$ est la variation relative de fréquence ;
- $\Delta T$ est la variation de la température ;
- $\dfrac{\partial E}{\partial T}\dfrac{1}{E}$ est la variation relative du module d'Young en fonction de la température, c'est-à-dire le coefficient thermoélastique (CTE) du spiral ;
- $\alpha_s$ est le coefficient de dilatation du spiral, exprimé en ppm.°C$^{-1}$ ;
- $\alpha_b$ est le coefficient de dilatation du balancier, expri-mé en ppm.°C$^{-1}$ ;

Les oscillations de tout résonateur destiné à une base de temps ou de fréquence devant être entretenues, la dépendance thermique comprend également une contribution éventuelle du système d'entretien comme, par exemple, un échappement à ancre suisse (non représenté) coopérant avec la cheville 9 du plateau 11 également monté sur l'axe 7.

On comprend donc, à partir des formules (1)-(6), qu'il est possible d'appairer le spiral 5 avec le balancier 3 afin que la fréquence *f* du résonateur 1 soit quasiment insensible aux variations de température.

L'invention concerne plus particulièrement un résonateur 1 dans lequel le spiral 5 est utilisé pour compenser l'ensemble du résonateur 1, c'est-à-dire toutes les parties et notamment le balancier 3. Un tel spiral 5 est généralement appelé un spiral compensateur. C'est pourquoi, l'invention se rapporte à un procédé de fabrication permettant de garantir une très haute précision dimensionnelle du spiral et, incidemment, de garantir une raideur plus précise dudit spiral.

Selon l'invention, le spiral compensateur 5, 15 est formé à base d'un matériau, éventuellement revêtu d'une couche de compensation thermique, et destiné à coopérer avec un balancier 3 d'inertie prédéterminée. Toutefois, rien n'empêche de prévoir un balancier avec des masselottes déplaçables permettant d'offrir un paramètre de réglage avant ou après la vente de la pièce d'horlogerie.

L'utilisation d'un matériau, par exemple à base de silicium, de verre ou de céramique, pour la fabrication d'un spiral 5, 15 offre l'avantage d'être précis par les méthodes de gravage existantes et de posséder de bonnes propriétés mécaniques et chimiques en étant notamment très peu sensible aux champs magnétiques. Il doit en revanche être revêtu ou modifié superficiellement pour pouvoir former un spiral compensateur.

Préférentiellement, le matériau à base de silicium utilisé comme spiral compensateur peut être du silicium monocristallin quelle que soit son orientation cristalline, du silicium monocristallin dopé quelle que soit son orientation cristalline, du silicium amorphe, du silicium poreux, du silicium polycristallin, du nitrure de silicium, du carbure de silicium, du quartz quelle que soit son orientation cristalline ou de l'oxyde de silicium. Bien entendu d'autres matériaux peuvent être envisagés comme un verre, une céramique, un cermet, un métal ou un alliage métallique. Par simplification, l'explication ci-dessous sera portée sur un matériau à base de silicium.

Chaque type de matériau peut être modifié superficiellement ou revêtu d'une couche afin de compenser thermiquement le matériau de base comme expliqué ci-dessus.

Si l'étape de gravage de spiraux dans une plaquette à base de silicium, au moyen d'un gravage ionique réactif profond (également connu sous l'abréviation « D. R.I.E. »), est la plus précise, des phénomènes qui interviennent pendant le gravage ou entre deux gravages successifs peuvent néanmoins induire des variations géométriques.

Bien entendu, d'autres types de fabrication peuvent être mis en oeuvre, comme le gravage laser, le gravage ionique localisé (connu sous l'abréviation anglaise « F.I.B. »), la croissance galvanique, la croissance par dépôt chimique en phase gazeuse ou le gravage chimique, qui sont moins précis et pour lesquels le procédé aurait encore plus de sens.

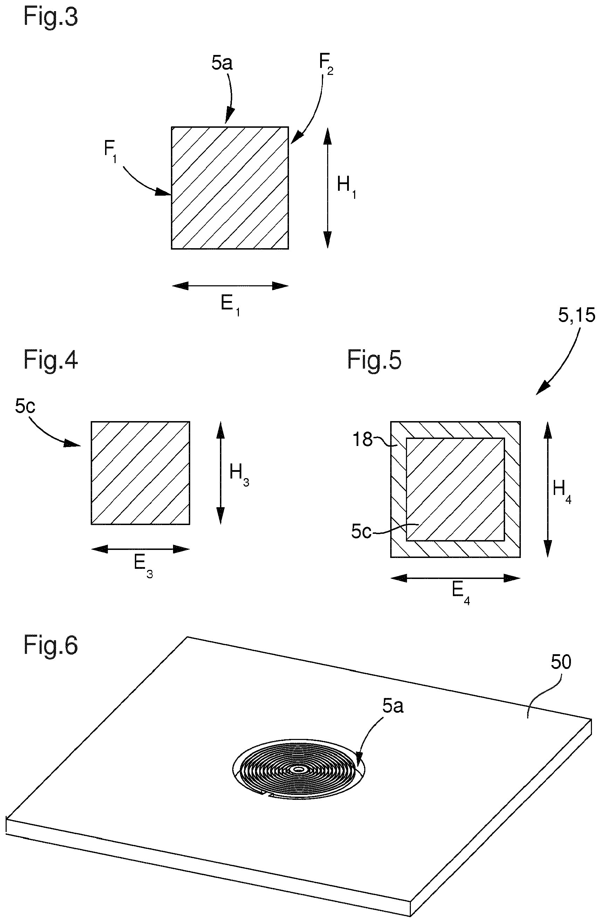

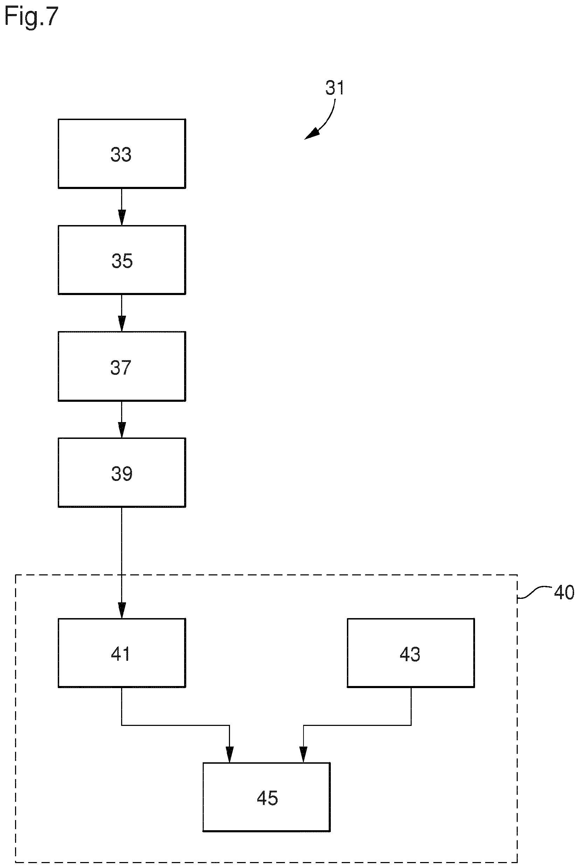

Ainsi, l'invention se rapporte à un procédé 31 de fabrication d'un spiral 5c. Selon l'invention, le procédé 31 comporte, comme illustré à la figure 7, une première étape 33 destinée à former au moins un spiral 5a, par exemple à base de silicium, selon des dimensions *Da* supérieures aux dimensions *Db* nécessaires pour obtenir ledit spiral 5c d'une raideur *C* prédéterminée. Comme visible à la figure 3, la section du spiral 5a comporte une hauteur H$_1$ et une épaisseur E$_1$.

Préférentiellement, les dimensions *Da* du spiral 5a sont sensiblement entre 1% et 20% supérieures à celles *Db* du spiral 5c nécessaires pour obtenir ledit spiral 5c d'une raideur *C* prédéterminée.

Préférentiellement selon l'invention, l'étape 33 est réalisée à l'aide d'un gravage ionique réactif profond dans une plaquette 50 d'un matériau à base de silicium comme illustré à la figure 6. Bien que cela ne soit pas représenté, les flancs opposés $F_1$, $F_2$ sont dans ce cas ondulés car un gravage ionique réactif profond du type Bosch occasionne une gravure en créneaux structurée par les étapes successives d'attaque et de passivation.

Bien entendu, le procédé ne saurait se limiter à une étape 33 particulière. A titre d'exemple, l'étape 33 pourrait tout aussi bien être obtenue par un gravage chimique dans une plaquette 50 d'un matériau par exemple à base de silicium. De plus, l'étape 33 signifie que un ou plusieurs spiraux sont formés, c'est-à-dire que l'étape 33 permet de former des spiraux en vrac ou alternativement formés dans une plaquette d'un matériau.

Par conséquent, lors de l'étape 33, plusieurs spiraux 5a peuvent être formés dans la même plaquette 50 selon des dimensions $Da$, $H_1$, $E_1$ supérieures aux dimensions $Db$, $H_3$, $E_3$ nécessaires pour obtenir plusieurs spiraux 5c d'une raideur $C$ prédéterminée ou plusieurs spiraux 5c de plusieurs raideurs $C$ prédéterminées.

L'étape 33 ne se limite pas non plus à la formation d'un spiral 5a selon des dimensions $Da$, $H_1$, $E_1$ supérieures aux dimensions $Db$, $H_3$, $E_3$ nécessaires pour obtenir un spiral 5c d'une raideur $C$ prédéterminée, formé à l'aide d'un unique matériau. Ainsi, l'étape 33 pourrait tout aussi bien former un spiral 5a selon des dimensions $Da$, $H_1$, $E_1$ supérieures aux dimensions $Db$, $H_3$, $E_3$ nécessaires pour obtenir un spiral 5c d'une raideur $C$ prédéterminée en un matériau composite, c'est-à-dire comportant plusieurs matériaux distincts.

Le procédé 31 comporte une deuxième étape 35 destinée à déterminer la raideur du spiral 5a. Une telle étape 35 peut être réalisée directement sur le spiral 5a encore attaché à la plaquette 50 ou sur le spiral 5a préalablement détaché de la plaquette 50, sur l'ensemble ou sur un échantillon des spiraux encore attachés à une plaquette 50 ou sur un échantillon de spiraux préalablement détachés d'une plaquette 50.

Selon l'invention, le spiral 5a étant ou non détaché de la plaquette 50, l'étape 35 comporte une première phase destinée à mesurer la fréquence $f$ d'un ensemble comportant le spiral 5a couplé avec un balancier doté d'une inertie $I$ prédéterminée puis, à l'aide de la relation (5), en déduire, dans une deuxième phase, la raideur $C$ du spiral 5a.

Une telle phase de mesure peut notamment être dynamique et réalisée selon les enseignements du document EP 2 423 764. Toutefois, alternativement, une méthode statique, réalisée selon les enseignements du document EP 2 423 764, peut également être mise en oeuvre pour déterminer la raideur C du spiral 5a.

Bien entendu, comme expliqué ci-dessus, le procédé ne se limitant pas au gravage d'un unique spiral par plaquette, l'étape 35 peut également consister en une détermination de la raideur moyenne d'un échantillon représentatif ou de l'ensemble des spiraux formés sur une même plaquette.

Selon l'invention, à partir de la détermination de la raideur $C$ du spiral 5a, le procédé 31 comporte une étape 37 destinée à calculer, à l'aide de la relation (2), l'épaisseur de matériau à retirer sur l'ensemble du spiral pour obtenir les dimensions globales $Db$ nécessaires pour obtenir ledit spiral 5c d'une raideur $C$ prédéterminée, c'est-à-dire le volume de matériau à retirer sur la surface du spiral 5a.

Le procédé se poursuit avec une étape 39 destinée à retirer la matière excédentaire du spiral 5a jusqu'aux dimensions $Db$ nécessaires pour obtenir ledit spiral 5c d'une raideur $C$ prédéterminée. On comprend donc qu'il importe peu que les variations géométriques soient intervenues sur l'épaisseur et/ou la hauteur du spiral 5a dans la mesure où, selon l'équation (2), c'est le produit $h \cdot e^3$ qui détermine la rigidité de la spire.

Selon invention, le retrait de la matière excédentaire du spiral 5a est effectué de manière non homogène, c'est-à-dire d'une manière qui varie le long du spiral 5a. Ainsi, par exemple, de la matière du spiral 5a peut être retirée uniquement dans des zones ou tronçons discrets dudit spiral, ou peut être retirée tout le long du spiral mais plus dans certaines zones que dans d'autres, ou peut être retirée selon l'épaisseur $E_1$ dans certaines zones et selon la hauteur $H_1$ dans d'autres zones. Les dimensions précitées $Db$, $H_3$, $E_3$ nécessaires pour obtenir le spiral 5c d'une raideur $C$ prédéterminée sont donc des dimensions moyennes (moyennées sur la longueur du spiral) de la section du spiral 5c. Comme montré à la figure 4, ces dimensions $Db$ comprennent une hauteur moyenne $H_3$ et une épaisseur moyenne $E_3$. La hauteur moyenne $H_3$ est inférieure à la hauteur $H_1$ du spiral 5a, et/ou l'épaisseur moyenne $E_3$ est inférieure à l'épaisseur $E_1$ du spiral 5a. Comme il ressort de la formule (2), l'épaisseur de matière à retirer pour obtenir la raideur $C$ prédéterminée est bien moindre si elle est retirée selon l'épaisseur $E_1$ de la section du spiral 5a plutôt que selon la hauteur $H_1$. Toutefois, un retrait de matière selon l'épaisseur $E_1$ nécessite une plus grande précision d'usinage.

Retirer la matière excédentaire de manière non homogène le long du spiral 5a à l'étape 39 présente plusieurs avantages :

i) la fabrication du spiral 5c peut être plus rapide et moins coûteuse du fait que l'enlèvement de matière n'a pas besoin d'être effectué sur tout le spiral ;

ii) il est possible de limiter l'enlèvement de matière à des zones du spiral qui sont plus accessibles que d'autres, par exemple la première et/ou la dernière spire et/ou des spires ayant un pas plus grand, afin d'éviter de toucher ou contaminer des spires adjacentes ;

iii) selon le procédé utilisé pour l'étape 39, enlever de la matière sur des longueurs plus courtes et pendant un temps plus court peut favoriser une meilleure maîtrise du procédé, en termes par exemple d'alignement du dispositif d'usinage ou de dérive de la puissance d'usinage ;

iv) une moins grande précision d'usinage est nécessaire pour obtenir la raideur $C$ prédéterminée, en particulier dans le cas d'un enlèvement de matière selon l'épaisseur $E_1$, puisque l'épaisseur à retirer dans les zones choisies est plus grande que l'épaisseur qui devrait être retirée sur toute la longueur du spiral 5a pour obtenir la même raideur $C$ ;

v) dans le cas d'un spiral 5a de section non constante, l'enlèvement de matière peut être avantageusement effectué dans les zones du spiral 5a où les dimensions de la section sont les plus grandes, pour mieux maîtriser l'effet de modification de la raideur C du spiral, ou inversement dans les zones les moins rigides du spiral 5a pour gagner en rapidité et en coût de fabrication ;

vi) si l'enlèvement de matière modifie l'état de surface, entraînant par là une dégradation de la tenue mécanique ou de l'esthétique, on peut choisir d'enlever la matière uniquement dans des zones qui sont moins sollicitées mécaniquement ou qui ne sont pas visibles.

Dans un mode de réalisation particulier, le retrait de matière à l'étape 39 est effectué au moyen d'un laser. Toutefois, des variantes sont possibles, telles que le gravage chimique ou le gravage ionique localisé, utilisant des masques pour protéger les zones du spiral dans lesquelles l'enlèvement de matière n'est pas souhaité. Une autre variante, dans le cas d'un matériau à base de silicium, peut consister à oxyder le spiral 5a dans des zones déterminées, à l'aide de masques, afin de transformer l'épaisseur de matériau à retirer en dioxyde de silicium, puis à retirer l'oxyde. L'oxydation peut être réalisée thermiquement, par exemple entre 800 et 1200°C sous atmosphère oxydante à l'aide de vapeur d'eau ou de gaz de dioxygène. Les masques peuvent être en nitrure. L'oxyde formé sur le silicium peut être retiré par un bain chimique comportant par exemple de l'acide fluorhydrique.

Selon l'agencement des zones choisies pour le retrait de matière à l'étape 39, le défaut d'isochronisme du résonateur balancier-spiral dû au développement du spiral 5c sera ou non modifié par rapport au spiral 5a formé à l'étape 33. En effet, en fonctionnement, selon l'agencement desdites zones choisies, le développement du spiral 5c sera plus ou moins concentrique, générant des forces plus ou moins grandes sur les pivots du balancier et sur le point d'encastrement du spiral. On sait qu'un spiral conventionnel à section constante se développe excentriquement. Un spiral à section variable peut, selon les cas, se développer plus concentriquement, moins concentriquement ou aussi concentriquement qu'un spiral à section constante et ainsi respectivement améliorer, détériorer ou conserver l'isochronisme. Dans la présente invention, il est possible de retirer la matière excédentaire du spiral 5a à l'étape 39 sans dégrader l'isochronisme et tout en obtenant une partie au moins des avantages i) à vi) énoncés ci-dessus.

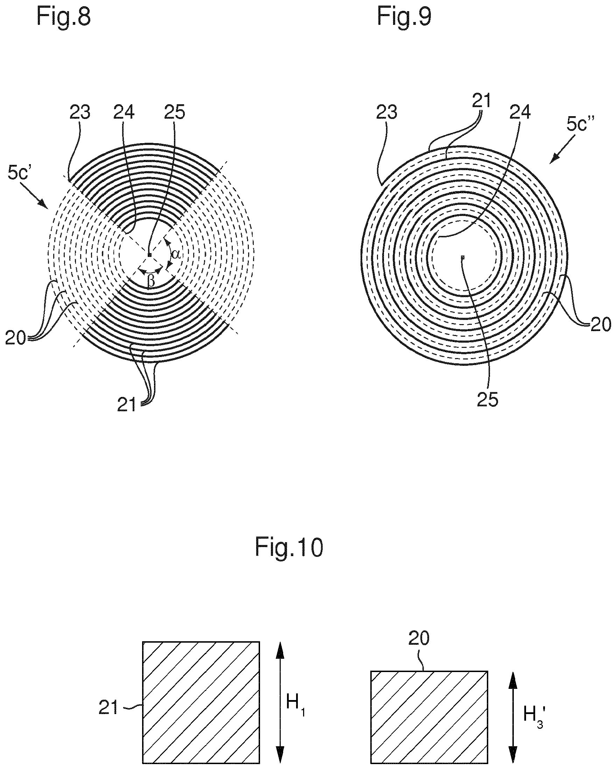

Pour illustrer cette caractéristique de l'invention, les figures 8 et 9 montrent deux exemples de spiraux 5c', 5c" comportant chacun des premières zones discrètes 20, représentées en traits pointillés, dans lesquelles du matériau a été enlevé à l'étape 39. Ces premières zones discrètes 20 alternent, le long du spiral, avec des deuxièmes zones discrètes 21, représentées en traits pleins, dans lesquelles aucun enlèvement de matériau n'a été effectué. Dans les premières zones discrètes 20, la hauteur du spiral a été diminuée de $H_1 = 120\ \mu m$ à $H_3' = 100\ \mu m$, par exemple par ablation laser, alors que dans les deuxièmes zones discrètes 21 la hauteur du spiral a été maintenue inchangée à $H_1 = 120\ \mu m$ (cf. figure 10). L'épaisseur de spire $E_1$ n'est pas modifiée le long du spiral. Dans chacun de ces exemples, la hauteur moyenne $H_3$ du spiral, entre les hauteurs $H_1$ et $H_3'$, est celle permettant d'obtenir ladite raideur C prédéterminée. Préférentiellement, comme représenté, les premières zones discrètes 20 sont régulièrement réparties tout le long du spiral et ont une même étendue angulaire $\alpha$, mesurée depuis le centre géométrique du spiral, laquelle étendue angulaire $\alpha$ est identique à l'étendue angulaire $\beta$ des deuxièmes zones discrètes 21. Il pourrait cependant en être autrement. Dans les exemples des figures 8 et 9, l'étendue angulaire $\alpha = \beta$ est de 90° et de 360°, respectivement.

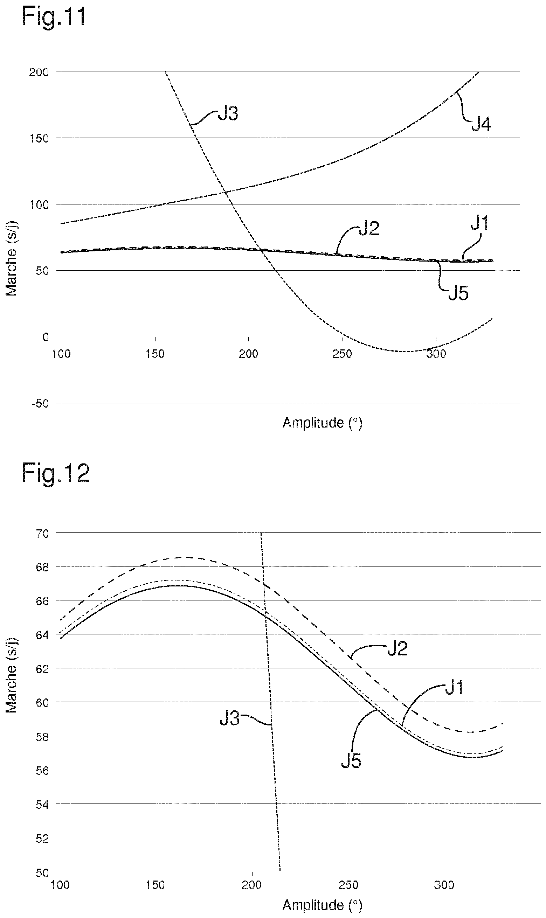

Les figures 11 et 12 montrent des courbes d'isochronisme J1 à J5 obtenues à partir de différents spiraux, à savoir pour la courbe J1 le spiral 5c' illustré à la figure 8, pour la courbe J2 le spiral 5c" illustré à la figure 9, pour la courbe J3 un spiral qui diffère des spiraux 5c' et 5c" en ce que les zones discrètes 20, 21 s'étendent chacune sur 180°, pour la courbe J4 un spiral qui diffère des spiraux 5c' et 5c" en ce que les zones discrètes 20, 21 s'étendent chacune sur 210°, et pour la courbe J5 le spiral 5a à section constante obtenu à l'étape 33. Ces courbes d'isochronisme J1 à J5 représentent, pour chaque spiral, les variations de la marche du résonateur balancier-spiral, en secondes/jour, en fonction de l'amplitude d'oscillation du résonateur balancier-spiral, en degrés. Seules les variations de marche dues au développement excentrique du spiral sont prises en compte ici, ce qui signifie qu'on ne tient pas compte notamment des effets dus au balancier ni des écarts de marche entre les différentes positions du résonateur.

Chaque courbe J1 à J5 est obtenue par simulation numérique, en considérant l'extrémité extérieure 23 du spiral comme fixe et l'arbre de balancier auquel est fixée l'extrémité intérieure 24 comme libre (c'est-à-dire non monté dans des paliers), en calculant par éléments finis le déplacement du centre de rotation 25 du spiral lors des oscillations du balancier, puis en interpolant et intégrant la courbe de déplacement en fonction de l'amplitude d'oscillation. Des équations analytiques reliant le déplacement du centre de rotation 25 du spiral à la marche en fonction de l'amplitude d'oscillation du balancier sont proposées par exemple dans l'ouvrage « Traité de construction horlogère » de M. Vermot, P. Bovay, D. Prongué et S. Dordor, édité par les Presses polytechniques et universitaires romandes, 2011. Les éventuels contacts entre les spires pendant les expansions et contractions du spiral ne sont pas pris en compte dans ces simulations, ces contacts pouvant dans chaque cas être évités par une simple adaptation du pas du spiral et/ou un écartement de la dernière spire.

Comme on peut le voir sur ces figures 11 et 12, les spiraux 5c' et 5c" (courbes J1, J2) produisent sensiblement les mêmes variations de marche que le spiral 5a (courbe J5). En revanche, les spiraux correspondant aux courbes J3 et J4 dégradent l'isochronisme du résonateur par rapport au spiral 5a, ceci à cause d'un développement très excentrique. Des résultats similaires seraient obtenus en modifiant non pas la hauteur du spiral 5a mais son épaisseur.

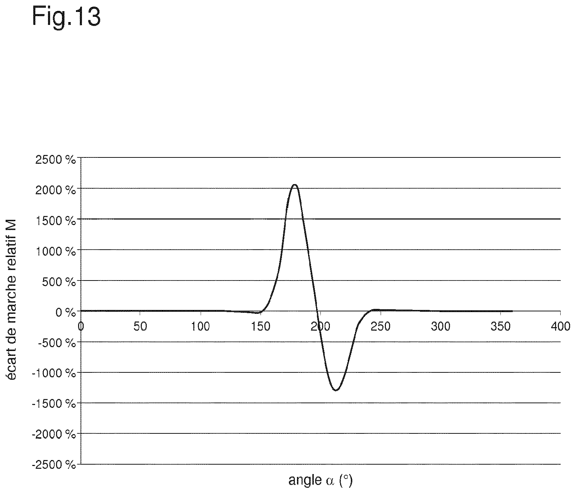

A la figure 13 est représenté l'écart de marche relatif M en fonction de l'étendue angulaire α, en degrés, de chaque zone discrète 20, 21. Par « écart de marche relatif » on entend la grandeur suivante, exprimée en pourcentage :

$$M = \frac{M_\alpha - M_c}{M_c}$$

où $M_\alpha$ est la différence entre la marche à 150° et la marche à 330° pour un spiral 5c donné ayant des zones discrètes 20, 21 d'étendue angulaire α, et $M_c$ est la différence entre la marche à 150° et la marche à 330° pour le spiral 5a correspondant à section constante. On peut déduire de ce diagramme que pour des angles α compris entre 0° et 140° ou compris entre 240° et 360°, le spiral 5c dégrade peu, voire ne dégrade pas, l'isochronisme du résonateur par rapport au spiral 5a, l'écart de marche relatif M en valeur absolue étant inférieur à 20% et pouvant même être inférieur à 10% voire à 5%. La grandeur $M_\alpha - M_c$ en valeur absolue peut, elle, être inférieure à 5 secondes/jour.

L'étape 39 peut finir le procédé 31. Toutefois, après l'étape 39, le procédé 31 peut également effectuer, au moins une nouvelle fois, les étapes 35, 37 et 39 dans le but d'encore affiner la qualité dimensionnelle du spiral. Ces itérations des étapes 35, 37 et 39 peuvent, par exemple, trouver un intérêt particulier quand l'exécution de la première itération des étapes 35, 37 et 39 est réalisée sur l'ensemble, ou sur un échantillon, des spiraux encore attachés à une plaquette 50, puis dans une deuxième itération, sur l'ensemble, ou un échantillon, des spiraux préalablement détachés de la plaquette 50 ayant subi la première itération.

Le procédé 31 peut également se poursuivre avec tout ou partie du processus 40 illustré à la figure 7 comportant des étapes optionnelles 41, 43 et 45. Avantageusement selon l'invention, le procédé 31 peut ainsi se poursuivre avec l'étape 41 destinée à former, sur au moins une partie du spiral 5c, une portion 18 permettant de former un spiral 5, 15 moins sensible aux variations thermiques.

Dans une première variante, l'étape 41 peut consister en une phase e1 destinée à déposer une couche sur une partie de la surface externe dudit spiral 5c d'une raideur C prédéterminée.

Dans le cas où le spiral 5c est en un matériau à base de silicium, la phase e1 peut consister à oxyder le spiral 5c pour le revêtir de dioxyde de silicium afin de former un spiral qui est thermocompensé. Une telle phase e1 peut, par exemple, être obtenue par oxydation thermique. Une telle oxydation thermique peut, par exemple, être réalisée entre 800 et 1200 °C sous atmosphère oxydante à l'aide de vapeur d'eau ou de gaz de dioxygène permettant de former de l'oxyde de silicium sur le spiral 5c.

On obtient ainsi le spiral 5, 15 compensateur comme illustré à la figure 5 qui, avantageusement selon l'invention, comporte une âme à base de silicium et un revêtement 18 à base d'oxyde de silicium. Avantageusement selon l'invention, le spiral 5, 15 compensateur possède donc une très haute précision dimensionnelle notamment quant à la hauteur $H_4$ et l'épaisseur $E_4$, et, incidemment, une compensation thermique de l'ensemble du résonateur 1 très fine.

Dans le cas d'un spiral à base de silicium, les dimensions globales *Db* peuvent être trouvées en utilisant les enseignements du document EP 1 422 436 pour l'appliquer au résonateur 1 qui est destiné à être fabriqué, c'est-à-dire pour compenser l'ensemble des parties constituantes du résonateur 1 comme expliqué ci-dessus.

Dans une deuxième variante, l'étape 41 peut consister en une phase e2 destinée à modifier la structure selon une profondeur prédéterminée d'une partie de la surface externe dudit spiral 5c d'une raideur C prédéterminée. A titre d'exemple, si un silicium amorphe est utilisé, il peut être prévu de le cristalliser selon une profondeur prédéterminée.

Dans une troisième variante, l'étape 41 peut consister en une phase e3 destinée à modifier la composition selon une profondeur prédéterminée d'une partie de la surface externe dudit spiral 5c d'une raideur C prédéterminée. A titre d'exemple, si un silicium monocristallin ou polycristallin est utilisé, il peut être prévu de le doper ou d'y diffuser des atomes interstitiels ou de substitution selon une profondeur prédéterminée.

Avantageusement selon l'invention, il est ainsi possible de fabriquer, comme illustré à la figure 2, sans plus de complexité un spiral 5c, 5, 15 comportant notamment :

- une ou plusieurs spires de section(s) plus précise(s) que celle obtenue par un unique gravage ;

- des variations d'épaisseur et/ou de pas le long de la spire ;
- une virole 17 monobloc ;
- une spire interne 19 du type à courbe Grossmann ;
- une attache 14 de pitonnage monobloc ;
- un élément d'encastrement externe monobloc ;
- une portion 13 de la spire externe 12 surépaissie par rapport au reste des spires.

Enfin, le procédé 31 peut également comporter l'étape 45 destinée à assembler un spiral compensateur 5, 15 obtenu lors de l'étape 41, ou un spiral 5c obtenu lors de l'étape 39, avec un balancier d'inertie prédéterminée obtenu lors de l'étape 43 pour former un résonateur 1 du type balancier - spiral qui est compensé thermiquement ou non, c'est-à-dire dont la fréquence *f* est sensible ou non aux variations de température.

Bien entendu, la présente invention ne se limite pas à l'exemple illustré mais est susceptible de diverses variantes et modifications qui apparaîtront à l'homme de l'art. En particulier, comme expliqué ci-dessus, le balancier, même s'il comporte une inertie prédéfinie de construction, peut comporter des masselottes déplaçables permettant d'offrir un paramètre de réglage avant ou après la vente de la pièce d'horlogerie.

De plus, une étape supplémentaire, entre l'étape 39 et l'étape 41, ou entre l'étape 39 et l'étape 45, pourrait être prévue afin de déposer d'une couche fonctionnelle ou esthétique, comme, par exemple, une couche de durcissement ou une couche luminescente.

Il est également envisageable dans le cas où le procédé 31 effectue, après l'étape 39, une ou plusieurs itération(s) des étapes 35, 37 et 39 que l'étape 35 ne soit pas systématiquement mise en oeuvre.

## Revendications

1. Procédé (31) de fabrication d'un spiral (5c) d'une raideur (*C*) prédéterminée comportant les étapes suivantes :

   a) former (33) un spiral (5a) selon des dimensions ($Da, H_1, E_1$) supérieures aux dimensions ($Db, H_3, E_3$) nécessaires pour obtenir ledit spiral (5c) d'une raideur (*C*) prédéterminée ;
   b) déterminer (35) la raideur (*C*) du spiral (5a) formé lors de l'étape a) par mesure de la fréquence (*f*) dudit spiral (5a) couplé avec un balancier doté d'une inertie prédéterminée ;
   c) calculer (37) l'épaisseur de matériau à retirer, à partir de la détermination de la raideur (C) du spiral (5a) déterminé lors de l'étape b), pour obtenir les dimensions ($Db, H_3, E_3$) nécessaires pour obtenir ledit spiral (5c) d'une raideur (*C*) prédéterminée ;
   d) retirer (39) du spiral (5a) formé lors de l'étape a), ladite épaisseur de matériau permettant d'obtenir le spiral (5c, 5c', 5c") aux dimensions ($Db, H_3, E_3$) nécessaires à ladite raideur (*C*) prédéterminée, ladite épaisseur de matériau étant retirée de manière non homogène le long du spiral (5a),

   dans lequel, lors de l'étape d), ladite épaisseur de matériau est retirée de telle manière que ledit spiral (5c, 5c', 5c") d'une raideur (*C*) prédéterminée produise un écart de marche dû au défaut de concentricité de son développement qui soit égal ou qui diffère au maximum de ±20% de l'écart de marche correspondant produit par le spiral (5a) formé lors de l'étape a), lesdits écarts de marche étant mesurés chacun à une amplitude d'oscillation de 150° par rapport à une amplitude d'oscillation de 330°.

2. Procédé (31) de fabrication selon la revendication précédente, **caractérisé en ce que** les dimensions ($D\alpha, H_1, E_1$) du spiral (5a) formé lors de l'étape a) sont entre 1% et 20% supérieures à celles ($Db, H_3, E_3$) nécessaires pour obtenir ledit spiral (5c, 5c', 5c") à ladite raideur (*C*) prédéterminée.

3. Procédé (31) de fabrication selon la revendication 1 ou 2, **caractérisé en ce que** l'étape a) est réalisée à l'aide d'un gravage ionique réactif profond.

4. Procédé (31) de fabrication selon la revendication 1 ou 2, **caractérisé en ce que** l'étape a) est réalisée à l'aide d'un gravage chimique.

5. Procédé (31) de fabrication selon l'une des revendications précédentes, **caractérisé en ce que**, lors de l'étape a), plusieurs spiraux (5a) sont formés dans une même plaquette (50) selon des dimensions ($D\alpha, H_1, E_1$) supérieures aux dimensions ($Db, H_3, E_3$) nécessaires pour obtenir plusieurs spiraux (5c, 5c', 5c") d'une raideur (*C*) prédéterminée ou plusieurs spiraux (5c, 5c', 5c") de plusieurs raideurs (*C*) prédéterminées.

6. Procédé (31) de fabrication selon l'une des revendications précédentes, **caractérisé en ce que** le spiral (5a) formé lors de l'étape a) est à base de silicium.

7. Procédé (31) de fabrication selon l'une des revendications 1 à 5, **caractérisé en ce que** le spiral (5a) formé lors de l'étape a) est à base de verre.

8. Procédé (31) de fabrication selon l'une des revendications 1 à 5, **caractérisé en ce que** le spiral (5a) formé lors de l'étape a) est à base de céramique.

9. Procédé (31) de fabrication selon l'une des revendications 1 à 5, **caractérisé en ce que** le spiral (5a) formé lors de l'étape a) est à base d'un métal.

**10.** Procédé (31) de fabrication selon l'une des revendications 1 à 5, **caractérisé en ce que** le spiral (5a) formé lors de l'étape a) est à base d'un alliage métallique.

**11.** Procédé (31) de fabrication selon l'une des revendications précédentes, **caractérisé en ce que** l'étape b) comporte les phases suivantes :

   b1) mesurer la fréquence (*f*) d'un ensemble comportant le spiral (5a) formé lors de l'étape a) couplé avec un balancier doté d'une inertie prédéterminée ;
   b2) déduire de la fréquence (*f*) mesurée, la raideur (*C*) du spiral (5a) formé lors de l'étape a).

**12.** Procédé (31) de fabrication selon l'une des revendications précédentes, **caractérisé en ce que** l'étape d) comporte la phase suivante :
d1) usiner au moyen d'un laser le spiral (5a) formé lors de l'étape a) afin d'obtenir le spiral (5c, 5c', 5c") aux dimensions (*Db, $H_3$ , $E_3$* ) nécessaires à ladite raideur (*C*) prédéterminée.

**13.** Procédé (31) de fabrication selon la revendication 6, **caractérisé en ce que** l'étape d) comporte les phases suivantes :

   d2) oxyder le spiral (5a) formé lors de l'étape a) afin de transformer ladite épaisseur de matériau à base de silicium à retirer en dioxyde de silicium et ainsi former un spiral (5b) oxydé ;
   d3) retirer l'oxyde du spiral (5b) oxydé permettant d'obtenir le spiral (5c, 5c', 5c") aux dimensions (*Db, $H_3$ , $E_3$* ) nécessaires à ladite raideur (*C*) prédéterminée.

**14.** Procédé (31) de fabrication selon l'une des revendications 1 à 11, **caractérisé en ce que** l'étape d) comporte la phase suivante :
d4) graver chimiquement le spiral (5a) formé lors de l'étape a) afin d'obtenir le spiral (5c, 5c', 5c") aux dimensions (*Db, $H_3$ , $E_3$* ) nécessaires à ladite raideur (*C*) prédéterminée.

**15.** Procédé (31) de fabrication selon l'une des revendications précédentes, **caractérisé en ce que**, après l'étape d), le procédé effectue au moins une nouvelle fois les étapes b), c) et d) pour affiner la qualité dimensionnelle.

**16.** Procédé (31) de fabrication selon l'une des revendications précédentes, **caractérisé en ce que**, après l'étape d), le procédé comporte, en outre, l'étape suivante :
e) former, sur au moins une partie dudit spiral (5c, 5c', 5c") d'une raideur (*C*) prédéterminée, une portion permettant de corriger la raideur du spiral (5c, 5c', 5c") et de former un spiral (5, 15) moins sensible aux variations thermiques.

**17.** Procédé (31) de fabrication selon la revendication 16, **caractérisé en ce que** l'étape e) comporte la phase suivante :
e1) déposer une couche sur une partie de la surface externe dudit spiral (5c, 5c', 5c") d'une raideur (*C*) prédéterminée.

**18.** Procédé (31) de fabrication selon la revendication 16, **caractérisé en ce que** l'étape e) comporte la phase suivante :
e2) modifier la structure selon une profondeur prédéterminée d'une partie de la surface externe dudit spiral (5c, 5c', 5c") d'une raideur (*C*) prédéterminée.

**19.** Procédé (31) de fabrication selon la revendication 16, **caractérisé en ce que** l'étape e) comporte la phase suivante :
e3) modifier la composition selon une profondeur prédéterminée d'une partie de la surface externe dudit spiral (5c, 5c', 5c") d'une raideur (*C*) prédéterminée.

**20.** Procédé (31) de fabrication selon l'une des revendications précédentes, **caractérisé en ce que**, lors de l'étape d), ladite épaisseur de matériau est retirée de telle manière que ledit spiral (5c, 5c', 5c") d'une raideur (*C*) prédéterminée produise un écart de marche dû au défaut de concentricité de son développement qui soit égal ou qui diffère au maximum de $\pm 5$ secondes/jour de l'écart de marche correspondant produit par le spiral (5a) formé lors de l'étape a), lesdits écarts de marche étant mesurés chacun à une amplitude d'oscillation de 150° par rapport à une amplitude d'oscillation de 330°.

**21.** Procédé (31) de fabrication selon l'une des revendications précédentes, **caractérisé en ce que**, lors de l'étape d), ladite épaisseur de matériau est retirée dans des premières zones discrètes (20) du spiral (5a) formé lors de l'étape a) et n'est pas retirée dans des deuxièmes zones discrètes (21) qui alternent avec les premières zones discrètes (20) le long du spiral (5a).

**22.** Procédé (31) de fabrication selon la revendication 21, **caractérisé en ce que** les premières zones discrètes (20) ont sensiblement la même étendue angulaire ($\alpha$).

**23.** Procédé (31) de fabrication selon la revendication 21 ou 22, **caractérisé en ce que** les premières zones discrètes (20) sont réparties sensiblement régulièrement tout le long dudit spiral (5a) formé lors de l'étape a).

**24.** Procédé (31) de fabrication selon l'une des revendications 21 à 23, **caractérisé en ce que** les deuxièmes zones discrètes (21) ont sensiblement la même étendue angulaire ($\beta$).

**25.** Procédé (31) de fabrication selon la revendication 24, **caractérisé en ce que** les deuxièmes zones discrètes (21) ont sensiblement la même étendue angulaire que les premières zones discrètes (20).

**26.** Procédé (31) de fabrication selon l'une des revendications 21 à 25, **caractérisé en ce que** les premières zones discrètes (20) ont chacune une étendue angulaire inférieure à environ 140° ou comprise entre environ 240° et environ 360°.

**27.** Procédé (31) de fabrication selon l'une des revendications précédentes, **caractérisé en ce que**, lors de l'étape d), ladite épaisseur de matériau est retirée selon l'épaisseur ($E_1$) du spiral (5a) formé lors de l'étape a).

**28.** Procédé (31) de fabrication selon l'une des revendications 1 à 26, **caractérisé en ce que**, lors de l'étape d), ladite épaisseur de matériau est retirée selon la hauteur ($H_1$) du spiral (5a) formé lors de l'étape a).

**29.** Procédé (31) de fabrication selon l'une des revendications 1 à 26, **caractérisé en ce que**, lors de l'étape d), ladite épaisseur de matériau est retirée selon l'épaisseur ($E_1$) et la hauteur ($H_1$) du spiral (5a) formé lors de l'étape a).

**Patentansprüche**

**1.** Verfahren (31) zur Herstellung einer Spiralfeder (5c) mit einer vorbestimmten Steifigkeit (C), umfassend die folgenden Schritte:

    a) Bilden (33) einer Spiralfeder (5a) mit Abmessungen (Da, $H_1$, $E_1$) größer als die Abmessungen (Db, $H_3$, $E_3$), die erforderlich sind, um die Spiralfeder (5c) mit einer vorbestimmten Steifigkeit (C) zu erhalten;
    b) Bestimmen (35) der Steifigkeit (C) der im Schritt a) gebildeten Spiralfeder (5a) durch Messen der Frequenz (f) der Spiralfeder (5a), die mit einer Unruh mit vorbestimmter Trägheit gekoppelt ist;
    c) Berechnen (37) der zu entfernenden Materialdicke anhand der Bestimmung der im Schritt b) bestimmten Steifigkeit (C) der Spiralfeder (5a), um die Abmessungen (Db, $H_3$, $E_3$) zu erhalten, die erforderlich sind, um die Spiralfeder (5c) mit einer vorbestimmten Steifigkeit (C) zu erhalten;
    d) Entfernen (39) der Materialdicke von der im Schritt a) gebildeten Spiralfeder (5a), was ermöglicht, die Spiralfeder (5c, 5c', 5c") mit den Abmessungen (Db, $H_3$, $E_3$), die für die vorbestimmte Steifigkeit (C) erforderlich sind, zu erhalten, wobei die Materialdicke längs der Spiralfeder (5a) ungleichmäßig entfernt wird,

wobei im Schritt d) die Materialdicke in der Weise entfernt wird, dass die Spiralfeder (5c, 5c', 5c") mit einer vorbestimmten Steifigkeit (C) eine durch Rundlauffehler ihrer Abwicklung bedingte Gangabweichung hervorruft, die gleich der entsprechenden Gangabweichung, die durch die im Schritt a) gebildete Spiralfeder (5a) hervorgerufen wird, ist oder höchstens um $\pm$ 20 % hiervon abweicht, wobei die Gangabweichungen jeweils mit einer Schwingungsamplitude von 150° in Bezug auf eine Schwingungsamplitude von 330° gemessen werden.

**2.** Herstellungsverfahren (31) nach dem vorhergehenden Anspruch, **dadurch gekennzeichnet, dass** die Abmessungen (Da, $H_1$, $E_1$) der im Schritt a) gebildeten Spiralfeder (5a) zwischen 1 % und 20 % größer sind als jene (Db, $H_3$, $E_3$), die erforderlich sind, um die Spiralfeder (5c, 5c', 5c") mit der vorbestimmten Steifigkeit (C) zu erhalten.

**3.** Herstellungsverfahren (31) nach Anspruch 1 oder 2, **dadurch gekennzeichnet, dass** der Schritt a) mit Hilfe einer tiefen reaktiven Ionenätzung ausgeführt wird.

**4.** Herstellungsverfahren (31) nach Anspruch 1 oder 2, **dadurch gekennzeichnet, dass** der Schritt a) mit Hilfe einer chemischen Ätzung ausgeführt wird.

**5.** Herstellungsverfahren (31) nach einem der vorhergehenden Ansprüche, **dadurch gekennzeichnet, dass** im Schritt a) mehrere Spiralfedern (5a) gebildet werden aus einer Platte (50) mit Abmessungen (Da, $H_1$, $E_1$) größer als die Abmessungen (Db, $H_3$, $E_3$), die erforderlich sind, um mehrere Spiralfedern (5c, 5c', 5c") mit einer vorbestimmten Steifigkeit (C) oder mehrere Spiralfedern (5c, 5c', 5c") mit mehreren vorbestimmten Steifigkeiten (C) zu erhalten.

**6.** Herstellungsverfahren (31) nach einem der vorhergehenden Ansprüche, **dadurch gekennzeichnet, dass** die im Schritt a) gebildete Spiralfeder (5a) auf Siliciumbasis hergestellt ist.

**7.** Herstellungsverfahren (31) nach einem der Ansprüche 1 bis 5, **dadurch gekennzeichnet, dass** die im Schritt a) gebildete Spiralfeder (5a) auf Glasbasis hergestellt ist.

**8.** Herstellungsverfahren (31) nach einem der Ansprüche 1 bis 5, **dadurch gekennzeichnet, dass** die im Schritt a) gebildete Spiralfeder (5a) auf Keramikbasis hergestellt ist.

9. Herstellungsverfahren (31) nach einem der Ansprüche 1 bis 5, **dadurch gekennzeichnet, dass** die im Schritt a) gebildete Spiralfeder (5a) auf Metallbasis hergestellt ist.

10. Herstellungsverfahren (31) nach einem der Ansprüche 1 bis 5, **dadurch gekennzeichnet, dass** die im Schritt a) gebildete Spiralfeder (5a) auf Metalllegierungsbasis hergestellt ist.

11. Herstellungsverfahren (31) nach einem der vorhergehenden Ansprüche, **dadurch gekennzeichnet, dass** der Schritt b) die folgenden Phasen umfasst:

b1) Messen der Frequenz (f) einer Anordnung, die die im Schritt a) gebildete Spiralfeder (5a) umfasst, die mit einer Unruh mit einer vorbestimmten Trägheit gekoppelt ist;
b2) Herleiten der Steifigkeit (C) der im Schritt a) gebildeten Spiralfeder (5a) aus der gemessenen Frequenz (f).

12. Herstellungsverfahren (31) nach einem der vorhergehenden Ansprüche, **dadurch gekennzeichnet, dass** der Schritt d) die folgende Phase umfasst:
d1) Bearbeiten mittels eines Lasers der im Schritt a) gebildeten Spiralfeder (5a), um die Spiralfeder (5c, 5c', 5c") mit den für die vorbestimmte Steifigkeit (C) erforderlichen Abmessungen (Db, $H_3$, $E_3$) zu erhalten.

13. Herstellungsverfahren (31) nach Anspruch 6, **dadurch gekennzeichnet, dass** der Schritt d) die folgenden Phasen umfasst:

d2) Oxidieren der im Schritt a) gebildeten Spiralfeder (5a), um die zu entfernende Dicke des Materials auf Siliciumbasis in Siliciumdioxid umzuwandeln und um somit eine oxidierte Spiralfeder (5b) zu bilden;
d3) Entfernen des Oxids von der oxidierten Spiralfeder (5b), was ermöglicht, die Spiralfeder (5c, 5c', 5c") mit den für die vorbestimmte Steifigkeit (C) erforderlichen Abmessungen (Db, $H_3$, $E_3$) zu erhalten.

14. Herstellungsverfahren (31) nach einem der Ansprüche 1 bis 11, **dadurch gekennzeichnet, dass** der Schritt d) die folgende Phase umfasst:
d4) chemisches Ätzen der im Schritt a) gebildeten Spiralfeder (5a), um die Spiralfeder (5c, 5c', 5c") mit den für die vorbestimmte Steifigkeit (C) erforderlichen Abmessungen (Db, $H_3$, $E_3$) zu erhalten.

15. Herstellungsverfahren (31) nach einem der vorhergehenden Ansprüche, **dadurch gekennzeichnet, dass** das Verfahren nach dem Schritt d) mindestens einmal erneut die Schritte b), c) und d) ausführt, um die Abmessungsqualität zu verfeinern.

16. Herstellungsverfahren (31) nach einem der vorhergehenden Ansprüche, **dadurch gekennzeichnet, dass** das Verfahren nach dem Schritt d) weiterhin den folgenden Schritt umfasst:
e) Bilden mindestens eines Abschnitts auf einem Teil der Spiralfeder (5c, 5c', 5c") mit vorbestimmter Steifigkeit (C), der ermöglicht, die Steifigkeit der Spiralfeder (5c, 5c', 5c") zu korrigieren und eine Spiralfeder (5, 15) zu bilden, die gegenüber Wärmeschwankungen weniger empfindlich ist.

17. Herstellungsverfahren (31) nach Anspruch 16, **dadurch gekennzeichnet, dass** der Schritt e) die folgende Phase umfasst:
e1) Ablagern einer Schicht auf einem Teil der äußeren Oberfläche der Spiralfeder (5c, 5c', 5c") mit einer vorbestimmten Steifigkeit (C).

18. Herstellungsverfahren (31) nach Anspruch 16, **dadurch gekennzeichnet, dass** der Schritt e) die folgende Phase umfasst:
e2) Ändern der Struktur über eine vorbestimmte Tiefe eines Teils der äußeren Oberfläche der Spiralfeder (5c, 5c', 5c") mit einer vorbestimmten Steifigkeit (C).

19. Herstellungsverfahren (31) nach Anspruch 16, **dadurch gekennzeichnet, dass** der Schritt e) die folgende Phase umfasst:
e3) Ändern der Zusammensetzung über eine vorbestimmte Tiefe eines Teils der äußeren Oberfläche der Spiralfeder (5c, 5c', 5c") mit einer vorbestimmten Steifigkeit (C).

20. Herstellungsverfahren (31) nach einem der vorhergehenden Ansprüche, **dadurch gekennzeichnet, dass** im Schritt d) die Materialdicke in der Weise entfernt wird, dass die Spiralfeder (5c, 5c', 5c") mit einer vorbestimmten Steifigkeit (C) eine durch Rundlauffehler ihrer Abwicklung bedingte Gangabweichung hervorruft, die gleich der entsprechenden Gangabweichung, die durch die im Schritt a) gebildete Spiralfeder (5a) hervorgerufen wird, ist oder höchstens um ± 5 Sekunden/Tag hiervon abweicht, wobei die Gangabweichungen jeweils mit einer Schwingungsamplitude von 150° in Bezug auf eine Schwingungsamplitude von 330° gemessen werden.

21. Herstellungsverfahren (31) nach einem der vorhergehenden Ansprüche, **dadurch gekennzeichnet, dass** im Schritt d) die Materialdicke in ersten diskreten Bereichen (20) der im Schritt a) gebildeten Spiralfeder (5a) entfernt wird und in zweiten diskreten Bereichen (21), die sich mit den ersten diskreten Bereichen (20) längs der Spiralfeder (5a) abwechseln, nicht entfernt wird.

22. Herstellungsverfahren (31) nach Anspruch 21, **dadurch gekennzeichnet, dass** die ersten diskreten Bereiche (20) im Wesentlichen die gleiche Winkelausdehnung ($\alpha$) aufweisen.

23. Herstellungsverfahren (31) nach Anspruch 21 oder 22, **dadurch gekennzeichnet, dass** die ersten diskreten Bereiche (20) längs der im Schritt a) gebildeten Spiralfeder (5a) im Wesentlichen regelmäßig verteilt sind.

24. Herstellungsverfahren (31) nach einem der Ansprüche 21 bis 23, **dadurch gekennzeichnet, dass** die zweiten diskreten Bereiche (21) im Wesentlichen die gleiche Winkelausdehnung ($\beta$) aufweisen.

25. Herstellungsverfahren (31) nach Anspruch 24, **dadurch gekennzeichnet, dass** die zweiten diskreten Bereiche (21) im Wesentlichen die gleiche Winkelausdehnung wie die ersten diskreten Bereiche (20) aufweisen.

26. Herstellungsverfahren (31) nach einem der Ansprüche 21 bis 25, **dadurch gekennzeichnet, dass** die ersten diskreten Bereiche (20) jeweils eine Winkelausdehnung aufweisen, die kleiner als etwa 140° ist oder im Bereich von etwa 240° bis etwa 360° liegt.

27. Herstellungsverfahren (31) nach einem der vorhergehenden Ansprüche, **dadurch gekennzeichnet, dass** im Schritt d) die Materialdicke längs der Dicke ($E_1$) der im Schritt a) gebildeten Spiralfeder (5a) entfernt wird.

28. Herstellungsverfahren (31) nach einem der Ansprüche 1 bis 26, **dadurch gekennzeichnet, dass** im Schritt d) die Materialdicke längs der Höhe ($H_1$) der im Schritt a) gebildeten Spiralfeder (5a) entfernt wird.

29. Herstellungsverfahren (31) nach einem der Ansprüche 1 bis 26, **dadurch gekennzeichnet, dass** im Schritt d) die Materialdicke längs der Dicke ($E_1$) und längs der Höhe ($H_1$) der im Schritt a) gebildeten Spiralfeder (5a) entfernt wird.

**Claims**

1. Method (31) for fabrication of a balance spring (5c) of a predetermined stiffness ($C$) comprising the following steps:

   a) forming (33) a balance spring (5a) in dimensions ($Da$, $H_1$, $E_1$) greater than the dimensions ($Db$, $H_3$, $E_3$) necessary to obtain said balance spring (5c) of a predetermined stiffness ($C$);
b) determining (35) the stiffness ($C$) of the balance spring (5a) formed in step a) by measuring the frequency ($f$) of said balance spring (5a) coupled with a balance having a predetermined inertia;
c) calculating (37) the thickness of material to be removed, based on the determination of the stiffness ($C$) of the balance spring (5a) determined in step b), to obtain the dimensions ($Db$, $H_3$, $E_3$) necessary to obtain said balance spring (5c) of a predetermined stiffness ($C$);
d) removing (39) from the balance spring (5a) formed in step a), said thickness of material to obtain the balance spring (5c, 5c', 5c") having the dimensions ($Db$, $H_3$, $E_3$) necessary for said predetermined stiffness ($C$), said thickness of material being removed in a non-homogeneous manner along the balance spring (5a),

wherein, in step d), said thickness of material is removed in such a way that said balance spring (5c, 5c', 5c") having a predetermined thickness ($C$) produces a difference in rate due to the lack of concentricity of the development of the spring that is equal to or which differs by a maximum of ± 20% from the corresponding difference in rate produced by the balance spring (5a) formed in step a), said differences in rate each being measured at an oscillation amplitude of 150° in comparison with an oscillation amplitude of 330°C.

2. Fabrication method (31) according to the preceding claim, **characterised in that**, the dimensions ($Da$, $H_1$, $E_1$) of the balance spring (5a) formed in step a) are between 1% and 20% greater than those ($Db$, $H_3$, $E_3$) necessary to obtain said balance spring (5c, 5c', 5c") of said predetermined stiffness ($C$).

3. Fabrication method (31) according to claim 1 or 2, **characterised in that** step a) is achieved by means of a deep reactive ion etch.

4. Fabrication method (31) according to claim 1 or 2, **characterised in that** step a) is achieved by means of a chemical etch.

5. Fabrication method (31) according to one of the preceding claims, **characterised in that**, in step a), several balance springs (5a) are formed in the same wafer (50) in dimensions ($Da$, $H_1$, $E_1$) greater than the dimensions ($Db$, $H_3$, $E_3$) necessary to obtain several balance springs (5c, 5c', 5c") of a predetermined stiffness ($C$) or several balance springs (5c, 5c', 5c") of several predetermined stiffnesses ($C$).

6. Fabrication method (31) according to one of the preceding claims, **characterised in that** the balance spring (5a) formed in step a) is silicon-based.

7. Fabrication method (31) according to one of claims 1 to 5, **characterised in that** the balance spring (5a) formed in step a) is glass-based.

8. Fabrication method (31) according to one of claims 1 to 5, **characterised in that** the balance spring (5a) formed in step a) is ceramic-based.

9. Fabrication method (31) according to one of claims 1 to 5, **characterised in that** the balance spring (5a) formed in step a) is metal-based.

10. Fabrication method (31) according to one of claims 1 to 5, **characterised in that** the balance spring (5a) formed in step a) is metal-alloy-based.

11. Fabrication method (31) according to one of the preceding claims, **characterised in that** step b) includes the following phases:

    b1) measuring the frequency ($f$) of an assembly comprising the balance spring (5a) formed in step a) coupled to a balance having a predetermined inertia;
    b2) deducing from the measured frequency ($f$), the stiffness ($C$) of the balance spring (5a) formed in step a).

12. Fabrication method (31) according to one of the preceding claims, **characterised in that** step d) includes the following phase:
    d1) laser machining the balance spring (5a) formed in step a) to obtain the balance spring (5c, 5c', 5c") having the dimensions ($Db$, $H_3$, $E_3$) necessary for said predetermined stiffness ($C$).

13. Fabrication method (31) according to claim 6, **characterised in that** step d) includes the following phases:

    d2) oxidising the balance spring (5a) formed in step a) in order to transform said thickness of silicon-based material to be removed into silicon dioxide and thereby form an oxidised balance spring (5b);
    d3) removing the oxide from the oxidised balance spring (5b) to obtain the balance spring (5c, 5c', 5c") having the dimensions ($Db$, $H_3$, $E_3$) necessary for said predetermined stiffness ($C$).

14. Fabrication method (31) according to one of claims 1 to 11, **characterised in that** step (d) includes the following phase:
    d4) chemically etching the balance spring (5a) formed in step a) to obtain the balance spring (5c, 5c', 5c") having the dimensions ($Db$, $H_3$, $E_3$) necessary for said predetermined stiffness ($C$).

15. Fabrication method (31) according to one of the preceding claims, **characterised in that**, after step d), the method performs, at least once more, steps b), c) and d) to further improve the dimensional quality.

16. Fabrication method (31) according to one of the preceding claims, **characterised in that**, after step d), the method also includes the following step:
    e) forming, on at least one part of said balance spring (5c, 5c', 5c") of a predetermined stiffness ($C$), a portion for correcting the stiffness of the balance spring (5c, 5c', 5c") and for forming a balance spring (5, 15) that is less sensitive to thermal variations.

17. Fabrication method (31) according to claim 16, **characterised in that** step e) includes the following phase:
    e1) depositing a layer on one part of the external surface of said balance spring (5c, 5c', 5c") of a predetermined stiffness ($C$).

18. Fabrication method (31) according to claim 16, **characterised in that** step e) includes the following phase:
    e2) modifying the structure, to a predetermined depth, of one part of the external surface of said balance spring (5c, 5c', 5c") of a predetermined stiffness ($C$).

19. Fabrication method (31) according to claim 16, **characterised in that** step e) includes the following phase:
    e3) modifying the composition, to a predetermined depth, of one part of the external surface of said balance spring (5c, 5c', 5c") of a predetermined stiffness ($C$).

20. Fabrication method (31) according to one of the preceding claims, **characterised in that**, in step d), said thickness of material is removed such that said balance spring (5c, 5c', 5c") of a predetermined stiffness ($C$) produces a difference in rate due to the lack of concentricity of the development of the spring that is equal to or differs by a maximum of ± 5 seconds/day from the corresponding difference in rate produced by the balance spring (5a) formed in step a), said differences in rate each being measured at an oscillation amplitude of 150° in comparison with an oscillation amplitude of 330°C.

21. Fabrication method (31) according to one of the preceding claims, **characterised in that**, in step d), said thickness of material is removed from first discrete areas (20) of the balance spring (5a) formed in step a) and is not removed from second discrete areas (21) which alternate with the first discrete areas (20) along the balance spring (5a).

22. Fabrication method (31) according to claim 21, **characterised in that** the first discrete areas (20) have substantially the same angular extension ($\alpha$).

23. Fabrication method (31) according to claim 21 or 22, **characterised in that** the first discrete areas (20) are arranged substantially regularly along the entire said balance spring (5a) formed in step a).

24. Fabrication method (31) according to one of claims 21 to 23, **characterised in that** the second discrete areas (21) have substantially the same angular extension ($\beta$).

25. Fabrication method (31) according to claim 24, **characterised in that** the second discrete areas (21) have substantially the same angular extension as the first discrete areas (20).

26. Fabrication method (31) according to one of claims 21 to 25, **characterised in that** the first discrete areas (20) each have an angular extension less than approximately 140° or comprised between approximately 240° and approximately 360°.

27. Fabrication method (31) according to one of the preceding claims, **characterised in that**, in step d), said thickness of material is removed from the thickness ($E_1$) of the balance spring (5a) formed in step a).

28. Fabrication method (31) according to one of claims 1 to 26, **characterised in that**, in step d), said thickness of material is removed from the height ($H_1$) of the balance spring (5a) formed in step a).

29. Fabrication method (31) according to one of claims 1 to 26, **characterised in that**, in step d), said thickness of material is removed from the thickness ($E_1$) and the height ($H_1$) of the balance spring (5a) formed in step a).

Fig.1

Fig.2

Fig.3

Fig.4

Fig.5

Fig.6

Fig.7

Fig.8

Fig.9

Fig.10

## Fig.11

## Fig.12

Fig.13

# RÉFÉRENCES CITÉES DANS LA DESCRIPTION

**Documents brevets cités dans la description**

- EP 1422436 A
- EP 1213628 A
- EP 2423764 A

**Littérature non-brevet citée dans la description**

- **M. VERMOT ; P. BOVAY ; D. PRONGUÉ ; S. DOR-DOR.** Traité de construction horlogère. 2011